Europäisches Patentamt

European Patent Office

Office européen des brevets

(11) Publication number: **0 142 447**
**A2**

(12) # EUROPEAN PATENT APPLICATION

(21) Application number: **84402287.1**

(22) Date of filing: **13.11.84**

(51) Int. Cl.⁴: **H 01 L 23/30**
**H 01 L 23/48**

(30) Priority: **14.11.83 US 551258**

(43) Date of publication of application:
**22.05.85 Bulletin 85/21**

(84) Designated Contracting States:
**DE FR GB IT NL**

(71) Applicant: **FAIRCHILD CAMERA & INSTRUMENT
CORPORATION
464 Ellis Street
Mountain View California 94042(US)**

(72) Inventor: **Phy, William S.
25616 Moody Road
Los Altos Hills California 94022(US)**

(74) Representative: **Chareyron, Lucien et al,
Schlumberger Limited Service Brevets c/o Giers 12, place
des Etats Unis B.P. 121
F-92124 Montrouge Cédex(FR)**

(54) Semiconductor package.

(57) An embodiment of the present invention relates to a plastic encapsulated semiconductor device having a lead frame with a plurality of leads, a silicon chip having at least one contact pad supported thereon, and a wire having one end ball-bonded to the pad and the other end bonded to one lead. The lead frame, wire and contact pad are all composed of the same metal or an alloy of that same metal. Preferably, the lead frame, wire and contact pad contain a major amount of aluminum. While electrolyte is present in the plastic encapsulation, the formation of electrochemical cells is inhibited since no diverse metals are present. Accordingly, galvanic corrosion is inhibited.

FIG. 1

EP 0 142 447 A2

50.4270

0142447

## BACKGROUND OF THE INVENTION

The present invention relates to packaging techniques for semiconductor circuits and, in particular, to structures for providing electrical connections to semiconductor chips in plastic encapsulation. More specifically, one form of the invention relates to a plastic packaged semiconductor device having an electrical connection path including an aluminum lead frame, ball-bonded aluminum wire and an aluminum contact pad on the semiconductor chip. The structure resists galvanic corrosion.

In many conventional integrated circuit devices, one of two types of encapsulation are employed. In a first type of packaging, ceramic is used to encase the semiconductor device. U.S. Patent No. 3,617,819 discloses such a ceramic packaged device. Ceramic packages, however, are expensive and need to be heated in order to form the package. Moreover, lead frames used in such packages must be able to withstand the heating, and are typically made of metals which are not readily formable.

Plastic is a second type of encapsulation material. Plastic can be molded around a semiconductor chip and lead frame at lower temperatures than that at which ceramic packages are bonded or cured. In many of the plastic packages, a thin gold wire extends between the contact pad and a lead of the lead frame. However, even gold wires encapsulated in plastic may tend to corrode or deteriorate. In addition, the use of gold wire is expensive.

An object of the invention is to provide a plastic encapsulated semiconductor device with thin wire connections to leads which resist deterioration.

It is a further object of the invention to provide an inexpensively manufactured plastic encapsulated semiconductor device.

Another object of the invention is to provide a plastic encapsulated semiconductor device which does not require the use of gold interconnections or ceramic packages.

It is a further object of the invention to provide a plastic encapsulated semiconductor device which resists corrosion and is therefore less likely to fail than previous devices.

Another object of the invention is to provide a semiconductor device having a lead frame made of a readily formable metal.

These and other objects and features of the present invention will be apparent from this written description and the appended drawings.

## SUMMARY OF THE INVENTION

The invention relates to an electrical device which includes a metal lead frame having a plurality of leads and a semiconductor element having at least one metal contact pad supported thereon. A metal wire is bonded to the contact pad and to one lead of the lead frame to provide an electrical connection between the contact pad and the lead. A plastic insulating and supporting material encapsulates the semiconductor element, the contact pad, the wire and portions of the leads. According to the invention, the metal wire, lead frame and contact pad are each composed of the same metal or alloys of that same metal so as to inhibit the formation of electrochemical cells in the presence of electrolyte from the plastic.

The invention also relates to a semiconductor device having an aluminum lead frame with a plurality of leads. The device includes a semiconductor element mounted on the lead frame and having at least one aluminum contact pad deposited thereon. An aluminum wire is ball bonded to the contact pad and bonded to a lead of the lead frame. A hot molded plastic insulating and supporting material encapsulates the element, wire and portions of the aluminum lead frame. The aluminum lead frame remains sufficiently rigid for insertion into external circuits or circuit boards, after being subjected to elevated temperatures when the device is encapsulated in plastic.

## BRIEF DESCRIPTION OF THE DRAWINGS

Preferred embodiments of the invention will be described with reference to the accompanying figures, wherein like elements bear like reference numerals, and wherein:

Figure 1 is an enlarged perspective view of a plastic dual-in-line packaged (P-DIP) semiconductor device showing a portion broken away to expose a semiconductor element or chip;

Figure 2 is an enlarged plan view of the chip of Figure 1 encircled by leads from the lead frame;

Figure 3 is a schematic side view of a conventional P-DIP semiconductor device having a gold wire extending between an aluminum contact pad on the chip and a lead of a copper or iron alloy lead frame;

Figure 4 is a schematic side view of a P-DIP semiconductor device in accordance with one embodiment of the invention having an aluminum lead frame, an aluminum contact pad and an aluminum wire; and

Figure 5 is a pictorial view of an apparatus for forming ball bonds illustrating, in schematic form, an electrical circuit which may be employed to ball bond an aluminum wire to an aluminum contact pad.

## DETAILED DESCRIPTION

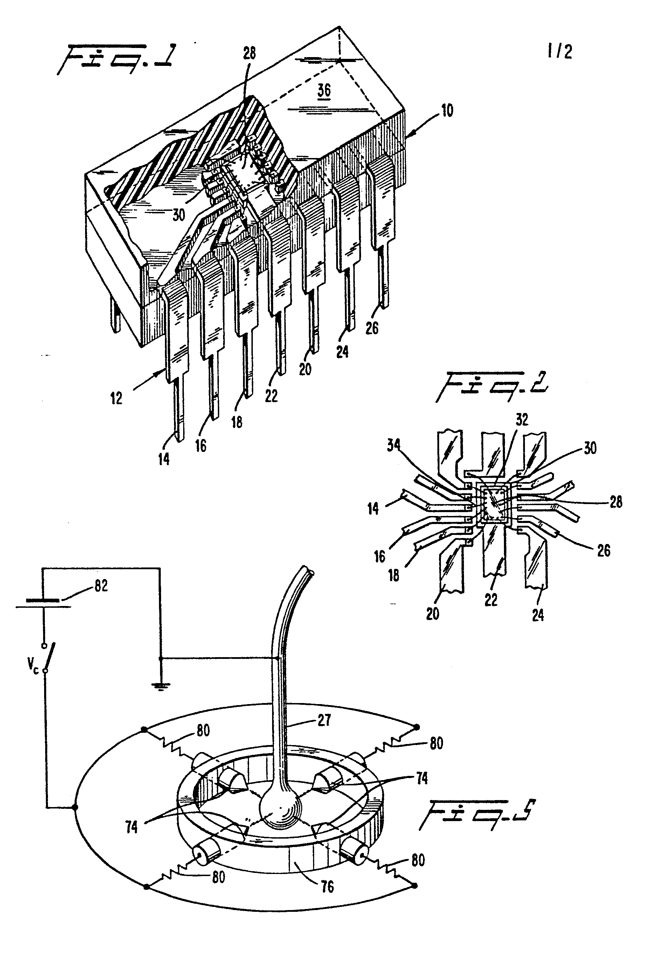

An embodiment of the present invention will be described with reference to Figure 1 which illustrates an exemplary structure consisting of a plastic dual-in-line package (P-DIP) semiconductor device 10. The device 10 has a metal lead frame 12 with a plurality of metal leads or arms 14, 16, 18, 20, 22, 24 and 26 extending from one side of the device. Counterpart leads (not shown) are located on an opposite side of the P-DIP semiconductor device. A semiconductor element, such as a silicon chip or die 28, is electrically connected or bonded to a paddle portion 30 of a support lead 22. The chip 28 may be connected to the paddle portion 30 by any conventional mechanism such as a conductive epoxy or eutectic die attachment.

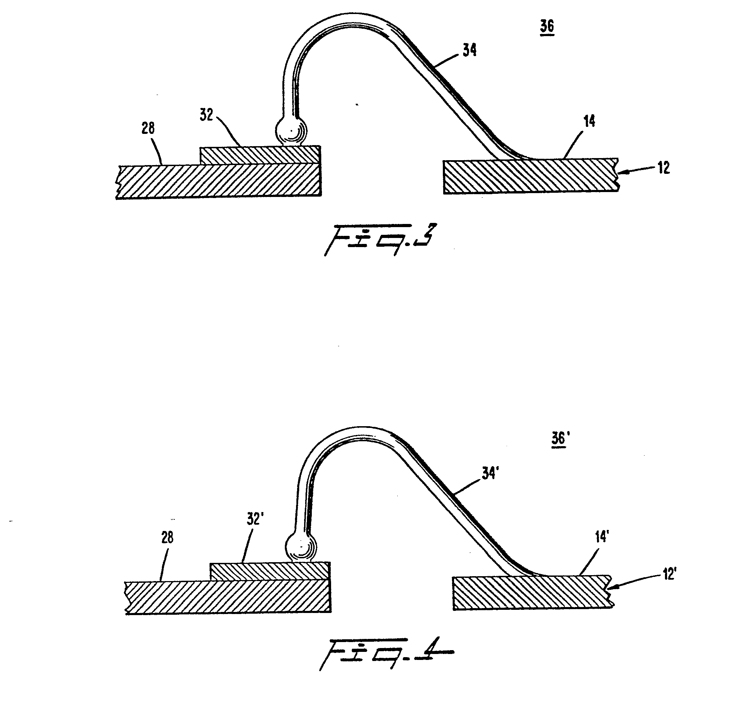

Figure 2 illustrates the leads encircling the chip 28. An end of each of thirteen leads is closely adjacent to the chip 28 with the leads being arranged in a generally radial array about the perimeter edge of the chip 28. The fourteenth lead 22 terminates in the paddle portion 30 which supports the chip 28. A plurality of electrical connection metal support or contact pads 32 are located in a similar general radial array on the peripheral margin of the chip 28. Preferably, the number of pads corresponds to the number of leads. An interconnecting metal wire 34 extends between each pad 32 and its corresponding lead for conducting electrical current between the chip 28 and the lead. The wire is preferably ball-bonded with a thermosonic or ultrasonic weld to the contact pad and with a thermosonic bond to the lead.

The chip 28 with its metallurgical components connected thereto (i.e., the leads, contact pads and wires) are encapsulated in an insulating material 36 (Figure 1). The material provides a package for containing the minute metallurgical components of the device. Portions of the leads extend out of the package in order to conduct the electrical current to and from the chip.

Figure 3 schematically illustrates one type of conventional metallurgical components for a P-DIP semiconductor device. In many instances, the contact pad 32 on the chip 28 is made from aluminum, while the lead frame 12 with lead 14 is usually formed from cladded or uncladded copper or iron alloy. When a gold wire 34 is extended between the pad 32 and the lead 14 and plastic 36 is molded about the components, ionic impurities in the plastic act as an electrolyte. That is, mobile ions within the plastic are available to interact with the diverse metals. An electrochemical or galvanic cell is produced by the aluminum wire/lead frame interface which results in a transfer of ions between the metals and the plastic, resulting in galvanic corrosion of the metals in the presence of the electrolyte. It is believed that the corrosion takes place at or near the midspan of the wire 34 based on the assumption that the highest potential is created in that region due to the different differential potentials at the extremes of the wire. In time, the corrosion may consume the wire, thereby interrupting the current path to the chip.

It is noted that gold wire has a greater resistance to corrosion than many other types of wire. Accordingly, gold wire is used in many conventional plastic packages, while increasing the cost of the device. In addition, it is noted that ceramic packages do not provide an electrolyte so that diverse metals may be encased in ceramic without forming an electrochemical cell. However, ceramic encapsulation is typically more expensive than plastic encapsulation.

In accordance with the invention, a semiconductor device is provided with a lead frame, a contact pad and a wire, all of which are composed of the same metal or alloys of that same metal. Since no diverse or dissimilar metals are present, the electrochemical cell cannot exist, even in the presence of electrolyte in the plastic. In a preferred embodiment, aluminum or aluminum alloys are used for the contact pads, lead frames and wire.

An embodiment of the invention will be described with reference to Figure 4 which schematically illustrates an exemplary metallurgical system for the lead frame, wire and contact pads. The silicon chip 28 has an aluminum pad 32' supported thereon. Preferably, the contact pad is deposited aluminum. The lead frame 12' and lead 14' are manufactured from aluminum and an aluminum wire 34' from 20 to 40 microns in thickness is electrically connected between the pad 32' and the lead 14'. Accordingly, there are no diverse metals at the wire/lead frame interface.

Preferably, the aluminum wire is ball-bonded to the contact pad 32'. An apparatus and a method for ball-bonding an aluminum wire is disclosed in a copending application titled "Method and Apparatus for Forming Ball Bonds" (by Shane Harrah and William Phy filed on July 25, 1983 and assigned to the assignee of the present application).

Figure 5 illustrates one embodiment of the apparatus for forming aluminum wire ball bonds. The apparatus includes a voltage source 82 connected to form a circuit consisting of plural electrically parallel legs. Each leg includes the series combination of a resistance element 80, an electrode 74 and an arc path 81 between the electrode and a tip of a wire 27. The electrically parallel legs may be arranged on an annulus 76 which surrounds the wire 27. The above-described electric al circuit aids in the production of a generally balanced, essentially simultaneous discharge from each electrode 74, even if the wire is not equidistantly spaced from the electrodes.

In forming the ball bond between the wire and a surface, the electrodes are symmetrically positioned about the tip of the wire with each electrode being connected in series with a resistance element and an arc path. A voltage source is applied to each electrode and arc path so that arcs are essentially simultaneously produced between the wire and each electrode to form the ball at the tip of the wire. The ball is approximately radially symmetric about a principal axis of the wire. The ball and a surface of the contact pad are then brought into contact with one another.

A plastic epoxy or epoxy derivative material 36' (Figure 4) may be used to encapsulate the chip 28, wire 34', pad 32' and portions of the leads 14' by a transfer molding process. In this process, the chip and its attached metallurgical components are placed in a mold and a pelletized epoxy material is heated and pressurized so that the material becomes semi-fluid. The material is introduced into the mold and cured in place about the metallurgical components. It is noted that the transfer molding process minimizes "wire wash" or deformation of the wire from its intended path during molding because transfer molding requires lower pressures than that required for injection molding.

Preferably, the components are solidly encapsulated with a minimal amount of voids within the plastic. The plastic is thus in very close proximity to the metallurgical components and in particular to the wire/lead frame interface. Accordingly, electrolytes may be in the vicinity of the metal components of the device. However, the formation of the galvanic reaction is inhibited because there are no dissimilar metal components at that interface.

It is noted that electrochemical or galvanic reaction may also be inhibited by employing a lead frame, wire and contact pad each of which contain a major amount of the same metal. For example, the wire may be manufactured from elemental aluminum, while the lead frame is composed of an aluminum alloy which contains a major amount of aluminum. Preferably, the major amount of the metal in the alloy is at least 98.0% of the alloy with the remaining composition of the alloy being, for example, 2.0% silicon or 1.5% silicon and 0.5% magnesium. While the formation of an electrochemical cell is possible with the metal and an alloy of that metal or with different alloys of the same metal, the voltage differential between the lead frame, wire and contact pad is insignificant when they all contain a major amount of the same metal. Accordingly, galvanic corrosion is inhibited.

In addition, the present invention relates to a plastic packaged semiconductor device having an elemental aluminum or aluminum alloy lead frame. Heretofore, essentially pure aluminum was not employed in ceramic packaged semiconductor devices since an aluminum lead frame deforms and becomes limp when exposed to the temperatures associated with firing or hardening of the ceramic (e.g., 400-500°C). However, transfer molding is done at considerably lower temperatures (e.g., approximately 150°C), so that an aluminum lead frame can be employed in a plastic packaged semiconductor device. It is advantageous to use an aluminum lead frame since it reduces the cost and the weight of the device and increases the tool life of the machines used to stamp the lead frame. A portion of such an aluminum lead frame 12' is illustrated in Figure 4 and the device shown in Figure 1 may also have an aluminum lead frame.

The principles, preferred embodiments and modes of operation of the present invention have been described in the foregoing specification. The invention which is intended to be protected herein, however, is not to be construed as limited to the particular forms disclosed, since these are to be regarded as illustrative rather than restrictive. Variations and changes may be made by those skilled in the art without departing from the spirit of the invention.

## CLAIMS

1. An electrical device, comprising:

a metal lead frame (12) having a plurality of leads (14, 16, 18, 20, 22, 24, 26);

a semiconductor element (28) having at least one metal contact pad (32) supported thereon;

a metal wire (34) bonded to said contact pad (32) and to one lead (14) of said lead frame (12) to provide an electrical connection between the contact pad and the lead; and

a plastic insulating and supporting material (36) encapsulating said semiconductor element (28), contact pad (32), wire (34) and portions of said leads; characterized in that:

the metal wire (34), lead frame (12) and contact pad (32) are each composed of the same metal or alloys of that same metal so as to inhibit formation of electrochemical cells in the presence of electrolyte from the plastic.

2. The device as recited in claim 1, characterized in that the lead frame, contact pad and wire contain a major amount of aluminum.

3. The device as recited in claim 2, characterized in that the major amount of aluminum is at least 90.0 %.

4. The device of any one of claims 1 to 3, characterized in that the contact pad (32) is deposited aluminum, the wire (34) is aluminum and the lead frame (12) is stamped aluminum alloy.

5.    The device of claim 4, characterized in that the aluminum wire (34) is ball-bonded to the aluminum contact pad (32).

FIG.1

FIG.2

FIG.3

<u>36</u>

34

28    32                    14

12

<u>Fig.3</u>

<u>36'</u>

34'

28    32'                   14'

12'

<u>Fig.4</u>